# EUROPEAN PATENT APPLICATION

(11) **EP 4 814 430 A1**
(43) Date of publication of application: **30.09.2026**
(21) Application number: 24894108.0
(22) Date of filing: 18.11.2024
(51) Int. Cl.: F28D 15/06, F28D 15/02, G03F 7/20, H01L 21/027, H01L 21/31, H01L 21/3065

(54) **COOLING DEVICE, SUBSTRATE PROCESSING DEVICE, AND METHOD FOR MANUFACTURING ARTICLE**

(30) Priority: 24.11.2023 JP 2023199252
(71) Applicant: Canon Kabushiki Kaisha, Tokyo 146-8501 (JP)
(72) Inventor: MORITA Tomoyuki, Tokyo 146-8501 (JP)
(74) Representative: Canon Europe Limited
(86) International application number: PCT/JP2024/040774
(87) International publication number: WO 2025/110117

(57) **Abstract**

A cooling apparatus configured to cool a target includes a pump configured to circulate a first refrigerant, a vaporizer configured to cool the target by vaporizing the first refrigerant, a condenser configured to condense the first refrigerant vaporized by the vaporizer, and a pressure control unit configured to control a pressure in a first portion where the first refrigerant is present in a vapor state in the condenser.

## Description

### Technical Field

The present disclosure relates to a cooling apparatus, a substrate processing apparatus, and a method for manufacturing an article.

### Background Art

A substrate processing apparatus, such as a patterning apparatus such as an exposure apparatus, an imprint apparatus, or an electron beam lithography apparatus, or a plasma processing apparatus such as a chemical vapor deposition (CVD) apparatus, an etching apparatus, or a sputtering apparatus, includes a heat generation portion such as a driving mechanism or a member heated by plasma. A cooling apparatus is provided to the substrate processing apparatus to cool such a heat generation portion. The cooling apparatus cools the heat generation portion by depriving the heat generation portion of heat and discharging the heat out of the apparatus.

Japanese Patent No. 5313384 describes a cooling system including an evaporator that extracts heat from a part, a condenser, a pump, an accumulator, a heat exchanger, and a temperature sensor. In this disclosure, a circuit is constructed to return a fluid transmitted from the pump to the pump via the evaporator and the condenser, and the accumulator is in fluid communication with the circuit. The heat exchanger transfers heat from the fluid in the accumulator and transfers heat to the fluid in the accumulator. The amount thereof is controlled based on an output from the temperature sensor.

The cooling system described in Japanese Patent No. 5313384 is required to avoid cavitation at a pump suction portion to stably circulate the fluid in the circuit that returns the fluid transmitted from the pump to the pump via the evaporator and the condenser. To fulfill that, a cooling mechanism is to be added to the condenser or a downstream or upstream side thereof to lower the fluid temperature or raise the pressure of the pump suction portion. Because the fluid is pressurized at the outlet of the pump, the fluid is delivered to the heat generation portion in a less evaporative state. Evaporative cooling is not started at the heat generation portion until the temperature of the fluid rises to the boiling point under the fluid pressure of the heat generation portion, which means that temperature fluctuations are permitted to continue at the heat generation portion during that and can lead to deformation of members near the heat generation portion due to thermal expansion. In light thereof, to suppress the temperature fluctuations, the boiling point is controlled by changing the vapor-liquid balance of the fluid with heat amount control to the accumulator so as to achieve a predetermined temperature on the downstream side of the heat generation portion using the accumulator of the fluid in two vapor and liquid phases, thereby changing the pressure in the whole system.

When the heat generation portion generates heat, the configuration described in Japanese Patent No. 5313384 collects heat from the accumulator to condense the fluid to lower the pressure in the circulation system, but this also lowers the pressure at the suction portion of the pump, thereby raising a risk of the occurrence of cavitation. Conversely, when the heat generation portion does not generate heat, heat is supplied to the accumulator to vaporize the fluid to raise the pressure in the circulation system.

Further, sealing chemically less reactive gas having a lower boiling point than the circulating fluid in a vapor-phase portion in the condenser allows a higher pressure to be present at the suction portion of the pump than the saturation water vapor pressure of the fluid with respect to the pressure in the evaporator, thereby contributing to suppressing the occurrence of cavitation.

However, dissolution of the sealed gas into the fluid or a leak of the gas out of the circulation system can accidentally cause a change in the partial pressure of the sealed gas, resulting in the occurrence of cavitation.

### Citation List

### Patent Literature

PTL 1: Japanese Patent No. 5313384

### Summary of Invention

### Technical Problem

The present disclosure is directed to providing a cooling apparatus, a substrate processing apparatus, and a method for manufacturing an article capable of suppressing the occurrence of cavitation.

### Solution to Problem

According to an aspect of the present disclosure, a cooling apparatus configured to cool a target includes a pump configured to circulate a first refrigerant, a vaporizer configured to cool the target by vaporizing the first refrigerant, a condenser configured to condense the first refrigerant vaporized by the vaporizer, and a pressure control unit configured to control a pressure in a first portion where the first refrigerant is present in a vapor state in the condenser.

### Advantageous Effects of Invention

According to the present disclosure, it is possible to provide a cooling apparatus, a substrate processing apparatus, and a method for manufacturing an article capable of suppressing the occurrence of cavitation.

### Brief Description of Drawings

[Fig. 1] Fig. 1 illustrates the configuration of a cooling apparatus according to a first embodiment.
[Fig. 2] Fig. 2 illustrates the configuration of a cooling apparatus according to a second embodiment.
[Fig. 3] Fig. 3 illustrates an example of the configuration of a substrate processing apparatus.
[Fig. 4] Fig. 4 illustrates an example of the configuration of a substrate processing apparatus.
[Fig. 5] Fig. 5 illustrates an example of the configuration of a substrate processing apparatus.
[Fig. 6] Fig. 6 is a flowchart illustrating manufacturing of a device.
[Fig. 7] Fig. 7 is a detailed flowchart of a wafer process in step 4 of the flowchart illustrated in Fig. 6.

### Description of Embodiments

In the following description, embodiments will be described in detail with reference to the attached drawings. However, the embodiments that will be described below are not intended to limit the disclosure defined according to the claims. A plurality of features will be described in the embodiments, but not this plurality of features is entirely necessarily essential to the disclosure and the plurality of features may be combined arbitrarily. Further, identical or similar configurations will be identified by the same reference numerals in the attached drawings, and redundant descriptions will be omitted. Further, the attached drawings may be drawn at a different scale from actual dimensions to facilitate the understanding of the present embodiments.

### <First Embodiment>

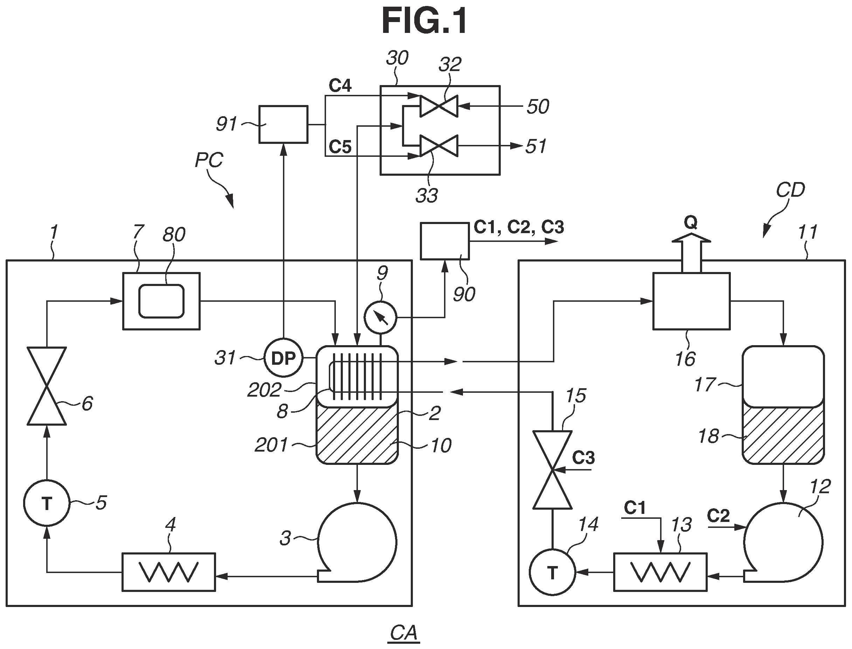

First, a cooling apparatus according to a first embodiment will be described. Fig. 1 illustrates the cooling apparatus according to the first embodiment. Examples of a target cooled by a cooling apparatus CA include, but not limited to specific targets, a substrate processing apparatus, in particular, a heat generation portion of a substrate processing apparatus. The substrate processing apparatus can be, for example, a patterning apparatus such as an exposure apparatus, an imprint apparatus, or a charged particle beam lithography apparatus, or a plasma processing apparatus such as a chemical vapor deposition (CVD) apparatus, an etching apparatus, or a sputtering apparatus. The patterning apparatus includes a driving mechanism that moves a substrate or an article such as a mask at a high speed, and this driving mechanism generates heat according to the driving of the article and can become the heat generation portion. In the plasma processing apparatus, a component such as an electrode is heated by plasma and this component can become the heat generation portion.

The cooling apparatus CA can include a first circulation system 1, which circulates a first refrigerant 10 from a condenser 2 so as to return it back to the condenser 2 via a vaporizer 7, and a cooling unit CD which includes a heat exchanger 8 disposed in the condenser 2. The first circulation system 1 can include a pump 3, which circulates the first refrigerant 10, a temperature controller 4, which adjusts the temperature of the first refrigerant 10 by heating or cooling the first refrigerant 10, or a throttle valve 6, which adjusts the pressure of the first refrigerant 10. The condenser 2 can include a second portion 201, in which the first refrigerant 10 is present in a liquid state, and a first portion 202, in which the first refrigerant 10 is present in a vapor state, and at least a part of the heat exchanger 8 (desirably, the entire heat exchanger 8) can be disposed in the first portion 202. A target 80 such as the heat generation portion can be cooled by the vaporizer 7.

The first circulation system 1 can be configured to cool the target 80 using a phase transition of the first refrigerant 10. The first circulation system 1 may include, for example, a sensor 5 that measures the temperature of the first refrigerant 10, besides the pump 3, the temperature controller 4, the throttle valve 6, and the vaporizer 7. The sensor 5 is disposed between the temperature controller 4 and the throttle valve 6 in Fig. 1, but may be disposed between the throttle valve 6 and the vaporizer 7. The first circulation system 1 can be a closed circulation system. The liquid-phase (liquid-state) first refrigerant 10 stored in the second portion 201 of the condenser 2 can be transmitted to the temperature controller 4 by the pump 3. The temperature controller 4 can adjust the temperature of the first refrigerant 10 in such a manner that the temperature of the first refrigerant 10 detected by the sensor 5 disposed on the downstream side of the temperature controller 4 matches a target temperature. The temperature controller 4 can include, for example, an electric heater or a heat exchanger, but is not limited thereto.

The first refrigerant 10 adjusted to the predetermined temperature can be depressurized to near the saturation vapor pressure of the first refrigerant 10 under the predetermined temperature by the throttle valve 6, and then transmitted to the vaporizer 7. The vaporizer 7 can be in thermal contact with the target 80 or have the target 80 built therein, and cool the target 80 with the aid of latent heat of vaporization in which the first refrigerant 10 in the vaporizer 7 boils when the target 80 generates heat. After passing through the vaporizer 7, the first refrigerant 10 can be returned to the condenser 2 in a liquid-phase state or a vapor-liquid mixed-phase state (a state containing liquid and vapor) according to the heat generation state of the target 80.

The heat exchanger 8 at least partially disposed in the first portion 202 inside the condenser 2 cools the first refrigerant 10, by which the first refrigerant 10 in the vapor-phase state is condensed into the first refrigerant 10 in the liquid-phase state. The cooling unit CD including the heat exchanger 8 can be constituted by, for example, a second circulation system 11, which circulates a second refrigerant 18 via the heat exchanger 8. The second circulation system 11 circulates the second refrigerant 18 independently of the circulation of the first refrigerant 10 in the first circulation system 1. The cooling apparatus CA can include a sensor 9, which detects the pressure or the temperature inside the condenser 2 (the first portion 202). A predetermined amount of a gas 50 (a first gas) can be sealed inside the condenser 2. The gas 50 can be a gas having a boiling point lower than that of the first refrigerant 10 and chemically nonreactive to the first refrigerant 10. For example, the gas 50 may be air or clean dry air (CDA), or may be inert gas such as nitrogen (N2).

The second circulation system 11 can be controlled based on an output of the sensor 9 in such a manner that the pressure or the temperature inside the condenser 2 (the first portion 202) matches a predetermined pressure or a predetermined temperature. It should be noted that, when the pressure of the first refrigerant 10 in the vaporizer 7 is controlled to match the saturation vapor pressure under the predetermined temperature, this means that the boiling point of the first refrigerant 10 is controlled. In a case of cooling using a heat transfer fluid, the temperature of the refrigerant rises by a degree corresponding to a value resulting from dividing a collected heat amount by the thermal capacity of the fluid according to the collected heat amount. However, in the case of boiling cooling, heat can be collected at a constant temperature set as the boiling point because being collected by the latent heat of vaporization.

In the case where the first circulation system 1 is a closed system, the pressures inside the vaporizer 7 and the condenser 2 rise when the first refrigerant 10 boils (vaporizes). This means that the saturation vapor pressure of the first refrigerant 10 rises, and causes a change in the boiling point as large as dT expressed by the following Clausius-Clapeyron equation.$dT = T Δ V ⋅ dP / L$ In this equation, dT represents the temperature change, T represents the state temperature, ΔV represents the volume change according to evaporation, dP represents the pressure change, and L represents the latent heat.

The gas 50 is sealed in the condenser 2 to keep the first refrigerant 10 inside the vaporizer 7 at the predetermined temperature and the predetermined saturation vapor pressure. The amount of the gas 50 sealed in the condenser 2 is such an amount that a differential pressure between the saturation vapor pressure of the first refrigerant 10 in the vaporizer 7 and the saturation vapor pressure of the first refrigerant 10 in the condenser 2 matches a partial pressure of the gas 50. In a case where there is a height difference between the vaporizer 7 and the condenser 2, the pressure is reduced by a degree corresponding to an elevation head ρgh (increased if h is negative), assuming that ρ represents the density of the first refrigerant 10, g represents the acceleration of gravity, and h represents the height of the vaporizer 7 with the condenser 2 set as a reference value.

Control in the second circulation system 11 will be described. The second refrigerant 18 used in the second circulation system 11 can be, for example, a fluid such as water. The second circulation system 11 can include a second pump 12, a second temperature controller 13, a second temperature sensor 14, a flow rate adjustment valve 15, the heat exchanger 8, a heat exhauster 16, and a tank 17. The second refrigerant 18 in the tank 17 can be transmitted to the second temperature controller 13 by the second pump 12. The second temperature controller 13 can adjust the temperature of the first refrigerant 10 by heating or cooling the second refrigerant 18 in such a manner that the temperature of the second refrigerant 18 detected by the second temperature sensor 14, which is disposed downstream of the second temperature controller 13, matches a predetermined temperature. The second refrigerant 18 heated or controlled to the predetermined temperature is adjusted to a predetermined flow rate by the flow rate adjustment valve 15, and is transmitted to the heat exchanger 8 and exchanges heat with the first refrigerant 10. Due to the heat exchange with the second refrigerant 18, the first refrigerant 10 is cooled and condensed. Heat of the second refrigerant 18 heated by latent heat of condensation of the first refrigerant 10 can be exhausted out of the system via the heat exhauster 16 and returned to the tank 17.

The cooling apparatus CA can include a control unit 90. The control unit 90 can generate control signals C1, C2, and C3 so as to maintain a constant pressure or temperature inside the condenser 2 (the first portion 202) of the first circulation system 1, and control the second refrigerant 18 by the control signals C1, C2, and C3. The control of the second refrigerant 18 by the control unit 90 can include control of at least one of the temperature, the flow rate, and the pressure of the second refrigerant 18 supplied to the heat exchanger 8. The control of the second refrigerant 18 by the control unit 90 may be understood as control of a condensation amount of the first refrigerant 10 by the heat exchanger 8. The control of the second refrigerant 18 by the control unit 90 can include, for example, feeding the control signal C1 according to the output of the sensor 9 to the second temperature controller 13 to control how much the second temperature controller 13 adjusts the temperature of the second refrigerant 18. The control of the second refrigerant 18 by the control unit 90 can include feeding the control signal C2 according to the output of the sensor 9 to the second pump 12 to control the output of the second pump 12 to thus control the flow rate and/or the pressure of the second refrigerant 18. The control of the second refrigerant 18 by the control unit 90 can include feeding the control signal C3 according to the output of the sensor 9 to the flow rate adjustment valve 15 to control the opening degree of the flow rate adjustment valve 15 to thus control the flow rate and/or the pressure of the second refrigerant 18. In other words, the control unit 90 can control at least one of the second pump 12 and the flow rate adjustment valve 15 based on the output of the sensor 9.

In the first embodiment, the cooling of the first refrigerant 10 by the second circulation system 11 is controlled in such a manner that the pressure or the temperature inside the condenser 2 matches the predetermined value while following the heat generation state of the target 80. Due to that, the boiling point of the first refrigerant 10 in the vaporizer 7 is fixed, and heat can be collected from the target 80 at a constant temperature. Further, the first embodiment controls the pressure or the temperature in the condenser 2 with the control target value of the cooling unit CD while following or predicting the heat generation state of the target 80, thereby controlling the pressure, that is, the boiling point in the vaporizer 7 to reduce a delay in the control of the cooling apparatus CA to improve the temperature stability. Further, when the target 80 is in a high heat generation state, the first embodiment can achieve efficient heat collection by lowering the boiling point of the first refrigerant 10 in the vaporizer 7 to below the temperature control target temperature of the target 80.

The first embodiment has been described above assuming that the cooling unit CD is configured to circulate the refrigerant (the second refrigerant 18) controlled in terms of the temperature and/or the flow rate by way of example. However, this is merely an example and can be modified as appropriate, and, for example, the cooling unit CD may be, for example, a refrigerator that transfers heat based on the heat pump principle.

The gas 50 of the predetermined amount is sealed inside the condenser 2 (the first portion 202), and the total pressure in the first portion 202 is a sum of the partial pressure of the gas 50 and the partial pressure of the first refrigerant 10. On the other hand, the inside of the vaporizer 7 is in a vapor-liquid mixed boiled state filled with the first refrigerant 10, and therefore no partial pressure is generated except for that of the first refrigerant 10 and the total pressure inside the vaporizer 7 corresponds to the saturation vapor pressure of the first refrigerant 10. The first embodiment lowers the partial pressure of the first refrigerant 10 in the first portion 202 to below the partial pressure of the first refrigerant 10 (= the total pressure) in the vaporizer 7, thereby allowing the first refrigerant 10 in the condenser 2 to have a dew point temperature lower than the boiling point temperature of the first refrigerant 10 in the vaporizer 7 by a degree corresponding to the partial pressure of the gas 50.

The first circulation system 1 is a closed circulation system, but, actually, the partial pressure of the first refrigerant 10 in the condenser 2 can be changed over time due to a leak or entry of external air via a joint portion or the like, dissolution of the gas 50 into the second portion 201, or the like. As a result, the difference between the boiling point of the first refrigerant 10 in the vaporizer 7 and the dew point of the first refrigerant 10 in the condenser 2 is also undesirably changed.

On the other hand, the pressure or the temperature inside the condenser 2 (the first portion 202) is controlled so as to be kept constant by the cooling unit CD. Provided that the total pressure in the first portion 202 is kept constant, the change in the partial pressure of the gas 50 can be detected by a dew point meter 31 as a change in the dew point of the first refrigerant 10. For example, if the partial pressure of the first refrigerant rises due to a leak, the dew point of the first refrigerant 10 also rises. When the partial pressure of the first refrigerant changes in this manner, the temperature control of the cooling apparatus CA can become unstable or uncontrollable.

A partial pressure controller 30 can include a supply valve 32 (a supply unit), which supplies the gas 50 (a first gas), and an exhaust valve 33 (an exhaust unit), which exhausts a gas 51 (a second gas) from the first portion 202. As a supply pressure of the gas 50, the gas 50 can be supplied at a pressure higher than the pressure in the first portion 202. Further, assume that the pressure in the first portion 202 of the condenser 2 is higher than a pressure at an exhaust destination. A not-illustrated orifice and/or needle valve can be further provided to the supply valve 32 and the exhaust valve 33 to adjust an intake or exhaust amount when the valve is opened. Further, the supply valve 32 and the exhaust valve 33 may use a mass flow controller or a flow rate adjustment valve to further correctly control the intake or exhaust amount.

A partial pressure control device PC can include the partial pressure controller 30, the dew point meter 31 (a detection unit) disposed inside the condenser 2 (the first portion 202), and a second control unit 91. The dew point meter 31 detects the dew point of the first refrigerant 10 in the first portion 202 including the vaporized first refrigerant 10. The second control unit 91 generates a control signal C4 for controlling the supply valve 32 and a control signal C5 for controlling the exhaust valve 33 so as to keep the dew point of the first refrigerant 10 in the first portion 202 within a predetermined range. The supply valve 32 and the exhaust valve 33 can control the partial pressure of the first refrigerant 10 according to the control signals C4 and C5 under an environment of the pressure or the temperature in the first portion 202 controlled by the cooling apparatus CA. In other words, the partial pressure controller 30 controls the pressure in the first portion 202 so as to keep the dew point of the first refrigerant 10 detected by the dew point meter 31 within the predetermined range.

In this manner, the cooling apparatus according to the first embodiment can maintain the constant partial pressure of the first refrigerant in the first portion 202, thereby suppressing the occurrence of cavitation at the pump 3, which circulates the first refrigerant.

### <Second Embodiment>

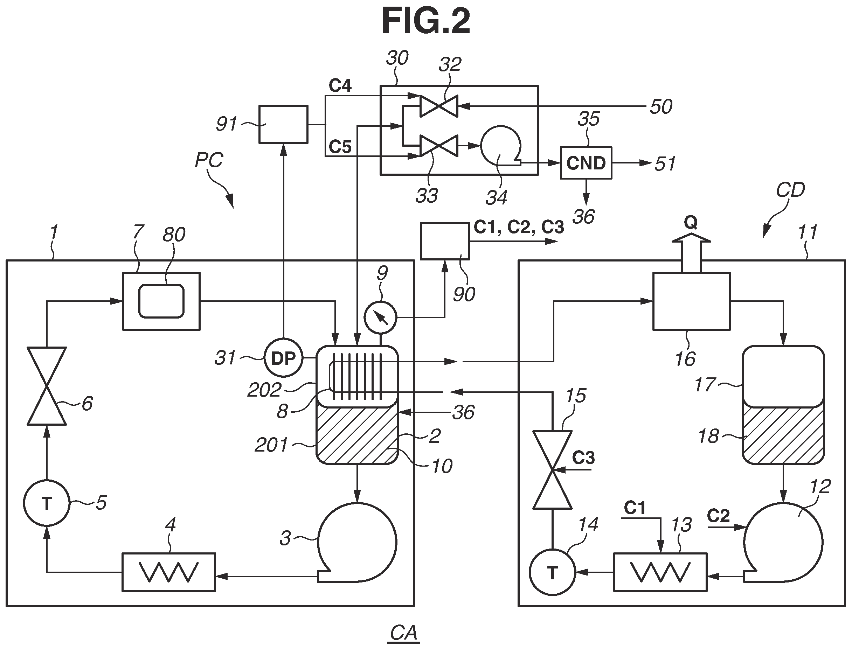

Next, a cooling apparatus according to a second embodiment will be described. Features that will not be described as the second embodiment can comply with the first embodiment. Fig. 2 illustrates the cooling apparatus according to the present embodiment. The partial pressure control device PC illustrated in Fig. 2 includes the partial pressure controller 30 configured differently from the partial pressure controller 30 according to the first embodiment. The first embodiment is constructed assuming that the pressure in the first portion 202 of the condenser 2 is higher than an air pressure (for example, an atmospheric pressure) at the exhaust destination, but the gas in the first portion 202 cannot be exhausted even by controlling the exhaust valve 33 when the pressure in the first portion 202 of the condenser 2 is lower than the air pressure at the exhaust destination. In light thereof, the partial pressure controller 30 illustrated in Fig. 2 can further include an exhaust pump 34 on the exhaust side of the exhaust valve 33. The exhaust pump 34 can allow the exhaust side of the exhaust valve 33 to have a pressure lower than the pressure in the first portion 202, and allow the exhaust to be controlled by the exhaust valve 33 even when the pressure in the first portion 202 is higher than the air pressure at the exhaust destination. Alternatively, the partial pressure controller 30 may be configured to include only the exhaust pump 34 instead of the exhaust valve 33. In this case, the operation of the exhaust pump 34 is controlled according to the control signal C5 issued from the second control unit 91. A not-illustrated orifice and/or needle valve can be further provided to adjust the intake or exhaust amount when the exhaust pump is operated.

The gas exhausted from inside the condenser 2 (the first portion 202) contains the vapor of the first refrigerant 10 according to the saturation vapor pressure, and the first refrigerant 10 in the first circulation system 1 is reduced due to the exhaust of this gas according to the partial pressure control by the partial pressure control device PC. In light thereof, a collection unit 35 can be provided on the exhaust side from the partial pressure controller 30. The collection unit 35 may be, for example, a heat exchanger with a refrigerant having a temperature equal to or lower than the dew point of the first refrigerant 10 at atmospheric pressure, or may be a condenser using a Peltier device. The first refrigerant 10 condensed and collected by the collection unit 35 can be returned to the condenser 2 via a liquid delivery unit 36 (not illustrated) such as a pump.

In this manner, the cooling apparatus according to the second embodiment can maintain the constant partial pressure of the first refrigerant in the first portion 202, thereby suppressing the occurrence of cavitation at the pump 3, which circulates the first refrigerant. Further, due to the collection unit 35, the cooling apparatus according to the second embodiment returns the first refrigerant 10 exhausted out of the first circulation system 1 to allow the flow amount of the first refrigerant 10 in the first circulation system 1 to be maintained, improving the stability of the temperature control.

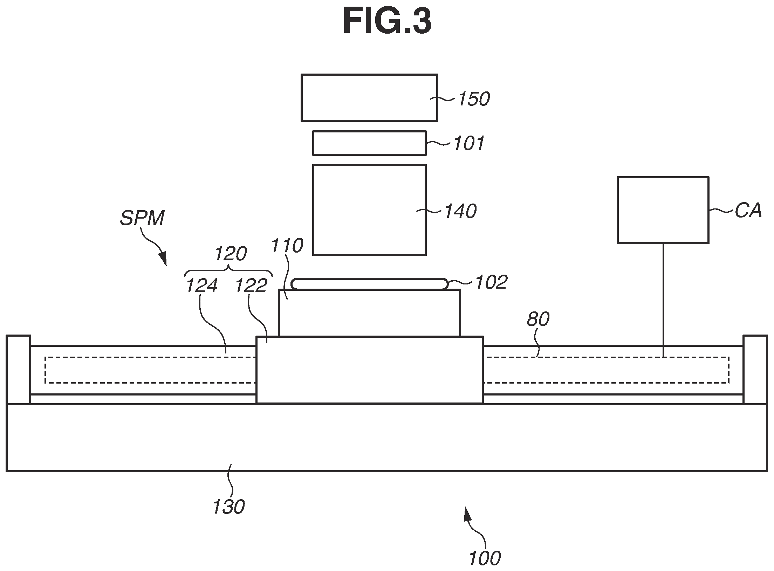

In the following description, a substrate processing apparatus to which the above-described cooling apparatus CA is applied will be described with reference to Figs. 3, 4, and 5 by way of example. Fig. 3 schematically illustrates the configuration of an exposure apparatus 100 as an example of the substrate processing apparatus, more specifically, a patterning apparatus. The exposure apparatus 100 can be configured to, to a substrate 102 having a photosensitive material layer, transfer a pattern of a mask 101 onto this photosensitive material layer by a projection optical system 140. The exposure apparatus 100 can include an illumination optical system 150, which illuminates the mask 101, the projection optical system 140, and a substrate positioning mechanism SPM. Further, the exposure apparatus 100 can include a mask positioning mechanism (not illustrated) for positioning the mask 101. The substrate positioning mechanism SPM can include a substrate stage 110, which includes a substrate chuck for holding the substrate 102, a driving mechanism 120, which drives the substrate stage 110, and a base member 130, which supports the driving mechanism 120. The driving mechanism 120 can include an actuator including a mover 1202, which moves together with the substrate stage 110, and a stator 124, which is fixed to the base member 130. The stator 124 can include a coil array as the target 80. The cooling apparatus CA can be configured to cool the coil array serving as the target 80.

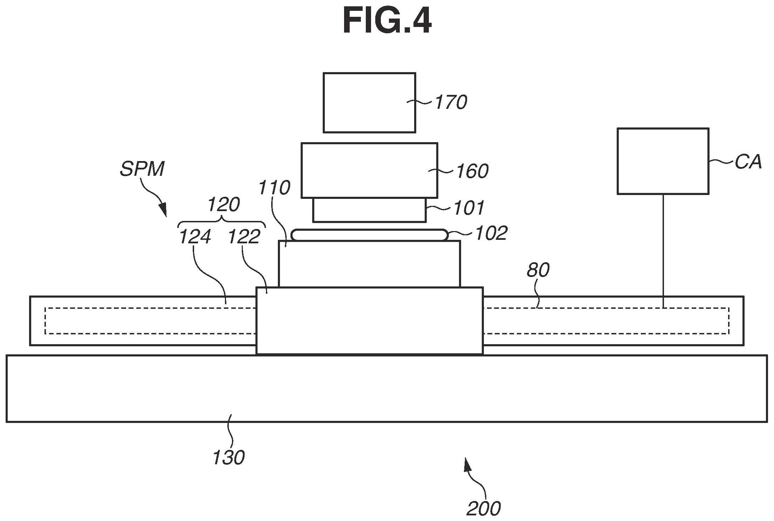

Fig. 4 schematically illustrates the configuration of an imprint apparatus 200 as an example of the substrate processing apparatus, more specifically, the patterning apparatus. The imprint apparatus 200 can be configured to transfer the pattern of the mask 101 to an imprint material on the substrate 102. The imprint apparatus 200 can include a mask driving mechanism 160, which drives the mask 101, the substrate positioning mechanism SPM, which drives the substrate 102, and a curing unit 170, which cures the imprint material disposed on the substrate 102.

A shot region of the substrate 102 and a pattern region of the mask 101 can be aligned by at least one of the mask driving mechanism 160 and the substrate positioning mechanism SPM. The imprint material disposed on the substrate 102 and the pattern region of the mask 101 can be brought into contact with each other and separated from each other by at least one of the mask driving mechanism 160 and the substrate positioning mechanism SPM. The imprint material is cured by the curing unit 170 with the imprint material disposed on the substrate 102 and the pattern region of the mask 101 placed in contact with each other. After that, the cured imprint material and the pattern region of the mask 101 are separated. As a result, a pattern made of the cured imprint material is formed on the substrate 102. In other words, the pattern region of the mask 101 is transferred to the imprint material on the substrate 102.

The substrate positioning mechanism SPM can include the substrate stage 110, which includes the substrate chuck for holding the substrate 102, the driving mechanism 120, which drives the substrate stage 110, and the base member 130, which supports the driving mechanism 120. The driving mechanism 120 can include the actuator including the mover 1202, which moves together with the substrate stage 110, and the stator 124, which is fixed to the base member 130. The stator 124 can include a coil array as the target 80. The cooling apparatus CA can be configured to cool the coil array serving as the target 80.

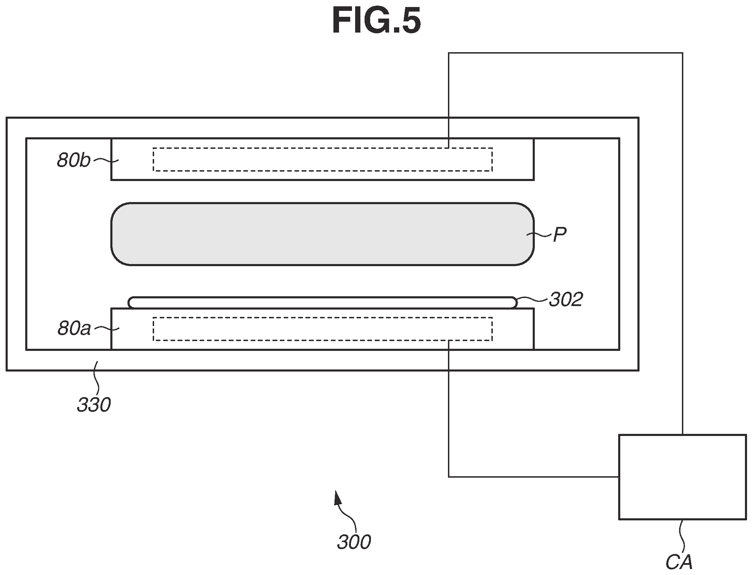

Fig. 5 schematically illustrates the configuration of a plasma processing apparatus 300 as an example of the substrate processing apparatus. The plasma processing apparatus 300 can be, for example, a CVD apparatus, an etching apparatus, or a sputtering apparatus. The plasma processing apparatus 300 can include a chamber 330, and an electrode structure serving as one or a plurality of targets 80a and 80b arranged in the chamber 330. In the example illustrated in Fig. 5, a substrate 302 can be supported by the target 80a. A gas for generating plasma can be supplied into the chamber 330. In the case where the plasma processing apparatus 300 is configured as a CVD apparatus, a gas for deposition can be supplied into the chamber 330. In the case where the plasma processing apparatus 300 is configured as an etching apparatus, a gas for etching can be supplied into the chamber 330. In the case where the plasma processing apparatus 300 is configured as a sputtering apparatus, a gas for generating plasma can be supplied into the chamber 330, and a target can be attached to the electrode structure serving as the target 80b.

The cooling apparatus CA can be configured to cool the targets 80a and 80b.

### <Method for Manufacturing Article>

A method for manufacturing an article as one aspect of the present disclosure can include processing a substrate by the substrate processing apparatus typified by the above-described exposure apparatus 100, imprint apparatus 200, and plasma processing apparatus 300, and further processing the substrate processed by the processing. The processing the substrate by the substrate processing apparatus can be, for example, forming a pattern on the substrate, forming a film on the substrate, or etching the substrate or a film formed on it. The further processing the substrate can be, for example, dividing (dicing) the substrate or sealing the substrate.

A method for manufacturing, for example, a device (a semiconductor device, a magnetic storage medium, a liquid crystal display element, or the like), a color filter, or a hard disk as the article will be described. This manufacturing method includes forming a pattern on a substrate by irradiating the substrate (a wafer, a glass plate, a film-shaped substrate, or the like) with light using the substrate processing apparatus (for example, an exposure apparatus) including the cooling apparatus that cools the heat generation portion. This manufacturing method further includes processing the substrate with the pattern formed thereon (processing). The processing can include removing a remaining film of the pattern. Further, the processing can include etching the substrate using the pattern as a mask. Further, the processing can include dicing, bonding, packaging, and/or the like as other known processing. The method for manufacturing the article according to the present embodiment is advantageous in terms of at least one of the performance, the quality, the productivity, and the production cost of the article compared with conventional techniques.

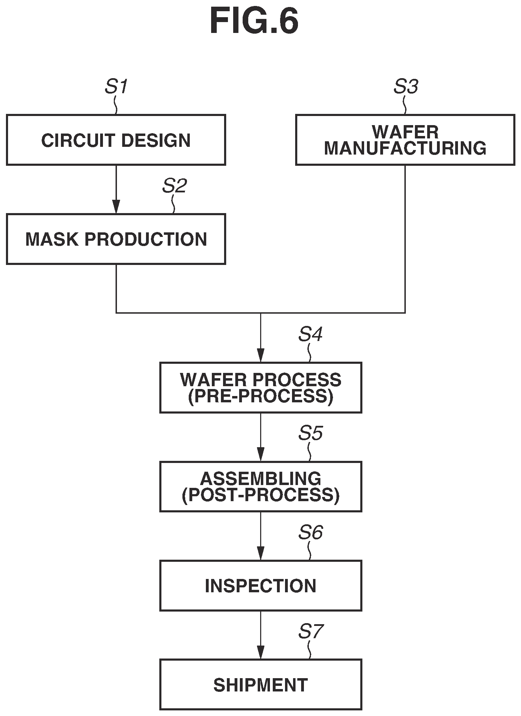

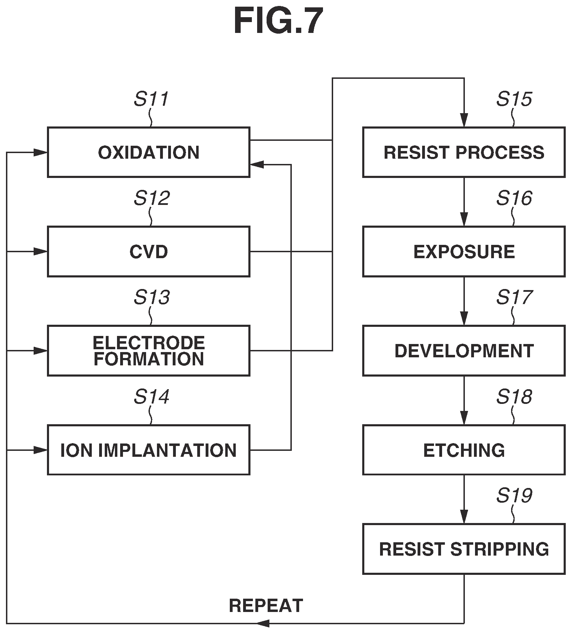

Next, an embodiment of a device manufacturing method using the above-described exposure apparatus will be described with reference to Figs. 6 and 7 as an example of the method for manufacturing the article. Fig. 6 is a flowchart illustrating manufacturing of a device (a semiconductor chip such as an integrated circuit (IC) or a large scale integrated circuit (LSI), a liquid crystal display (LCD), a charge-coupled device (CCD), or the like). In this example, a method for manufacturing a semiconductor chip will be described by way of example.

In step S1 (circuit design), a circuit of a semiconductor device is designed. In step S2 (mask production), a mask (a photomask) is produced based on the designed circuit pattern. In step S3 (wafer manufacturing), a wafer (a substrate) is manufactured using a material such as silicon. Step S4 (a wafer process) is called a pre-process, and an actual circuit is formed on the wafer using the mask and the wafer by the above-described exposure apparatus using the lithography technique. At this time, the exposure apparatus forms the circuit pattern on the wafer by illuminating the mask with the circuit pattern formed thereon and projecting an image of the circuit pattern of the mask onto the wafer. Step S5 (assembling) is called a post-process and is a process for transforming the wafer into a semiconductor chip using the wafer manufactured by step S4, and includes an assembling process such as an assembly process (dicing and bonding) and a packaging process (chip encapsulation). Step S6 (inspection) includes inspections such as an operation check test and a durability test of the semiconductor device manufactured in step S5. Through these steps, the semiconductor device is completed and is then shipped (step S7).

Fig. 7 is a detailed flowchart of the wafer process in step S4. In step S11 (oxidation), the surface of the wafer is oxidized. In step S12 (CVD), an insulating film is formed on the surface of the wafer. In step S13 (electrode formation), an electrode is formed on the wafer by vapor deposition. In step S14 (ion implantation), ions are implanted into the wafer. In step S15 (a resist process), a photosensitive agent is applied to the wafer. In step S16 (exposure), the circuit pattern of the mask is exposed on the wafer by the exposure apparatus. In step S17 (development), the exposed wafer is developed. In step S18 (etching), portions other than the developed resist image are cut out. In step S19 (resist stripping), the resist that has become unnecessary after the etching is completed is removed. By repeatedly performing these steps, multiple circuit patterns are formed on the wafer.

Although desirable embodiments of the present disclosure have been described, it is apparent that the present disclosure is not limited to these embodiments and can be modified and changed in various manners within the range of the spirit thereof.

Further, the exposure apparatus, the imprint apparatus, and the plasma processing apparatus have been described as examples of the substrate processing apparatus, but the substrate processing apparatus is not limited to them. The substrate processing apparatus may be a planarization apparatus that performs processing for molding a composition on a substrate so as to planarize it using a mold having a flat portion having no uneven pattern thereon (a flat template), as an example of the substrate processing apparatus. Alternatively, the substrate processing apparatus may be a lithography apparatus that performs processing for forming a pattern on a substrate by conducting lithography on the substrate with a charged particle beam (an electron beam, an ion beam, or the like) via a charged particle optical system, as an example of the substrate processing apparatus.

The present invention is not limited to the above embodiments and various changes and modifications can be made within the spirit and scope of the present disclosure. Therefore, to apprise the public of the scope of the present disclosure, the following claims are made.

This application claims priority from Japanese Patent Application No. 2023-199252, filed November 24, 2023, which is hereby incorporated by reference herein.

## Claims

1. A cooling apparatus configured to cool a target, the cooling apparatus comprising:
a pump configured to circulate a first refrigerant;
a vaporizer configured to cool the target by vaporizing the first refrigerant;
a condenser configured to condense the first refrigerant vaporized by the vaporizer; and
a pressure control unit configured to control a pressure in a first portion where the first refrigerant is present in a vapor state in the condenser.

2. The cooling apparatus according to claim 1, further comprising a detection unit disposed in the first portion and configured to detect a dew point of the first refrigerant present in the first portion,
wherein the pressure control unit controls the pressure in such a manner that the dew point of the first refrigerant detected by the detection unit falls within a predetermined range.

3. The cooling apparatus according to claim 1, wherein the pressure control unit includes a supply unit configured to supply a first gas to the first portion and an exhaust unit configured to exhaust a second gas from the first portion.

4. The cooling apparatus according to claim 3, wherein the exhaust unit includes an exhaust pump for exhausting the second gas.

5. The cooling apparatus according to claim 3, wherein the pressure control unit includes a collection unit configured to collect the vaporized first refrigerant contained in the second gas from the second gas.

6. The cooling apparatus according to claim 1, further comprising a temperature controller configured to control a temperature of the first refrigerant.

7. The cooling apparatus according to claim 1, further comprising a throttle valve configured to adjust a pressure of the first refrigerant.

8. The cooling apparatus according to claim 1, further comprising a sensor configured to measure a temperature of the first refrigerant.

9. The cooling apparatus according to claim 1, further comprising a cooling unit including a heat exchanger disposed in the condenser and configured to cool the first refrigerant.

10. A substrate processing apparatus configured to process a substrate, the substrate processing apparatus comprising:
a heat generation portion configured to generate heat; and
the cooling apparatus according to claim 1,
wherein the cooling apparatus is configured to cool the heat generation portion by vaporizing the first refrigerant with heat from the heat generation portion.

11. A method for manufacturing an article, comprising:
processing a substrate using the substrate processing apparatus according to claim 10;
further processing the processed substrate; and
manufacturing the article from the further processed substrate.
